# EUROPÄISCHE PATENTANMELDUNG

(11) **EP 1 054 511 A2**
(43) Veröffentlichungstag der Anmeldung: **22.11.2000**
(21) Anmeldenummer: 00107525.8
(22) Anmeldetag: 07.04.2000
(51) Int. Cl.: H03K 17/082, H01L 27/02

(54) **Verfahren zur Überstromabschaltung eines Bipolartransistors mit isoliert angeordneter Gateelektrode (IGBT) und Vorrichtung zur Durchführung des Verfahrens**

(30) Priorität: 27.04.1999 DE 19918966
(71) Anmelder: DaimlerChrysler AG, 70567 Stuttgart (DE)
(72) Erfinder: Hilpert, Gerald, 79787 Lauchringen (DE)
(74) Vertreter: Gmeiner, Christa, c/o DaimlerChrysler AG

(57) **Zusammenfassung**

Es wird ein Verfahren zur Überstromabschaltung eines Bipolartransistors mit isoliert angeordneter Gateelektrode (IGBT) (4) angegeben, welches die Gate-Kathodenspannung des Bipolartransistors mit isoliert angeordneter Gateelektrode (4) mittels einer Gate-Kathodenspannungsüberwachungseinrichtung (2) auf einen einstellbaren Schwellwert hin überwacht und bei Überschreiten des Schwellwertes unmittelbar auf einen einstellbaren Wert hin reduziert. Desweiteren wird der einstellbare Wert so eingestellt, dass die reduzierte Gate-Kathodenspannung den Bipolartransistor mit isoliert angeordneter Gateelektrode (4) unmittelbar abschaltet. In einem zweiten Schritt wird die reduzierte Gate-Kathodenspannung mittels eines Rückmeldesignals von einer Entsättigungsüberwachungseinrichtung (6) an eine Gateelektrodentreiberstufe (1) durch diese so weit reduziert, dass der Bipolartransistor mit isoliert angeordneter Gateelektrode (4) abgeschaltet wird.
Die Vorrichtung zur Durchführung des Verfahrens weist die Entsättigungsüberwachungseinrichtung (6) und die Gate-Kathodenspannungsüberwachungseinrichtung (2) auf, wobei die Gate-Kathodenspannungsüberwachungseinrichtung (2) eine Vergleicherschaltung mit Hysteresecharakteristik umfasst, die der Überwachung auf den einstellbaren Schwellwert und der Reduzierung der Gate-Kathodenspannung auf den einstellbaren Wert hin dient.

## Beschreibung

### Technisches Gebiet

Die Erfindung bezieht sich auf das Gebiet der Leistungselektronik. Sie geht aus von einem Verfahren zur Überstromabschaltung eines Bipolartransistors mit isoliert angeordneter Gateelektrode (IGBT) und einer Vorrichtung zur Durchführung des Verfahrens gemäss dem Oberbegriff der unabhängigen Ansprüche.

### Stand der Technik

Feldgesteuerte Halbleiterschalter, insbesondere Bipolartransistoren mit isoliert angeordneter Gateelektrode (IGBT), werden derzeit vermehrt in leistungselektronischen Anwendungen wie in der Stromrichtertechnik und insbesondere in Stromrichtern für elektrische Antriebe eingesetzt. Diese Bipolartransistoren mit isoliert angeordneter Gateelektrode werden über ihre Gateelektrode mit Hilfe einer Gateelektrodentreiberstufe durch Anlegen einer entsprechenden Gate-Kathodenspannung angesteuert.
Bei Fehlerfällen in Stromrichteranwendungen kann im Stromrichter in den eingesetzten Bipolartransistoren mit isoliert angeordneter Gateelektrode ein Kurzschluss im Hauptstrompfad des Stromrichters auftreten. Dieser Strom fliesst zwischen Anode und Kathode des Bipolartransistors mit isoliert angeordneter Gateelektrode. Im Kurzschlussfall steigt dabei der Strom im Hauptstrompfad sehr schnell auf eine hohe Stromamplitude an, so dass das Stromintegral über der Zeit unzulässig hohe Werte annimmt. Während dieses auftretenden Überstromes wird der Bipolartransistor mit isoliert angeordneter Gateelektrode in die Entsättigung getrieben, wobei die Anoden-Kathodenspannung am Bipolartransistor mit isoliert angeordneter Gateelektrode schnell ansteigt, insbesondere auf den Wert der zu schaltenden Spannung. Dadurch wird ein äusserst kritischer Zustand des Bipolartransistors mit isoliert angeordneter Gateelektrode erreicht: Der Bipolartransistor mit isoliert angeordneter Gateelektrode führt im Hauptstrompfad über die Anode und Kathode einen hohen Strom (Überstrom) bei gleichzeitig anliegender hoher Anoden-Kathodenspannung. Daraus resultiert eine extrem hohe momentane Verlustleistung, die den Bipolartransistor mit isoliert angeordneter Gateelektrode zerstören kann.

Hinzu kommt, dass über einen kapazitiven Spannungsteiler, der von der Anoden-Gatekapazität (Miller-Kapazität) und der Gate-Kathodenkapazität gebildet ist, im Kurzschlussfall des Bipolartransistors mit isoliert angeordneter Gateelektrode die Gate-Kathodenspannung durch den Anstieg der Anoden-Kathodenspannung während des Entsättigungsvorganges angehoben wird und der Bipolartransistor mit isoliert angeordneter Gateelektrode zusätzlich noch in eine höhere Entsättigungskennlinie gesteuert wird. Daraus resultiert eine weitere Erhöhung des Stromes über die Anode und Kathode (Überstrom), die eine zulässige Überstromdauer des Bipolartransistors mit isoliert angeordneter Gateelektrode erheblich verkürzt.

Eine Überstromschutzschaltungsanordnung für Halbleiterschalter, insbesondere für Bipolartransistoren mit isoliert angeordneter Gateelektrode, wie sie in 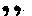 Fast Clamped Short Circuit Protection of IGBTs, John, Suh, Lipo, IEEE Applied Power Electronics Conference, Session 16.3, February 1998" beschrieben ist, überwacht zum einen die Anoden-Kathodenspannung auf Entsättigung des Bipolartransistors mit isoliert angeordneter Gateelektrode und misst zum anderen über eine parasitäre Kathodeninduktivität den Anodenstrom, der über die Stromänderung di/dt des Anodenstromes erfasst und aufintegriert wird.
Eine solche Lösung eignet sich jedoch nicht für gängige niederinduktive Bipolartransistoren mit isoliert angeordneter Gateelektrode, die durch viele parallele Strompfade im Bipolartransistor mit isoliert angeordneter Gateelektrode gekennzeichnet sind und für hohe Schaltspannungen ausgelegt sind. Mit einer di/dt Erfassung, wie sie in der oben genannten Schrift beschrieben ist, könnte immer nur ein Teil der Kathodeninduktivität und somit nur ein Teilstrom im Bipolartransistor mit isoliert angeordneter Gateelektrode überwacht werden, was zu einem sehr kleinem Nutzsignal führen würde, das zudem stark von hohen Schaltspannungen beeinflusst werden würde.

### Darstellung der Erfindung

Aufgabe der Erfindung ist es deshalb, ein Verfahren zur Überstromabschaltung eines Bipolartransistors mit isoliert angeordneter Gateelektrode (IGBT) anzugeben, durch welches beim Auftreten eines Überstromes zwischen Anode und Kathode des Bipolartransistors mit isoliert angeordneter Gateelektrode die Amplitude des Stromes und der Momentanwert der Verlustleistung reduziert wird und der Bipolartransistor mit isoliert angeordneter Gateelektrode abgeschaltet wird, sowie eine Vorrichtung anzugeben, mit der das Verfahren in besonders einfacher Weise durchgeführt wird. Diese Aufgabe wird durch die Merkmale der unabhängigen Ansprüche gelöst. Weitere vorteilhafte Ausgestaltungen der Erfindung sind in den Untersansprüchen angegegben.

Beim erfindungsgemässen Verfahren wird die Gate-Kathodenspannung mittels einer Gate-Kathodenspannungsüberwachungseinrichtung auf einen einstellbaren Schwellwert hin überwacht und bei Ansprechen der Überwachung auf Überschreiten des Schwellwertes unmittelbar auf einen einstellbaren Wert reduziert. Dadurch wird der Bipolartransistor mit isoliert angeordneter Gateelektrode vorteilhaft auf eine niedrige Entsättigungskennlinie ausgesteuert und somit der unerwünschte Überstrom zwischen Anode und Kathode des Bipolartransistors mit isoliert angeordneter Gateelektrode reduziert und die Verlustleistung gesenkt. Darüberhinaus wird das Gate-Oxid des Bipolartransistors mit isoliert angeordneter Gateelektrode durch die Reduzierung der Gate-Kathodenspannung vor Zerstörung durch Überspannung geschützt.

Die Reduzierung der Gate-Kathodenspannung erfolgt zum einen so, dass der einstellbare Wert der Gate-Kathodenspannung so eingestellt wird, dass die reduzierte Gate-Kathodenspannung den Bipolartransistor mit isoliert angeordneter Gateelektrode und somit den unerwünschten Überstrom direkt ohne Zwischenschritt abschaltet. Zum anderen wird ein Rückmeldesignal bei Entsättigung des Bipolartransistors mit isoliert angeordneter Gateelektrode mittels einer die Anoden-Kathodenspannung auf Entsättigung überwachende Entsättigungsüberwachungseinrichtung an eine Gateelektrodentreiberstufe gesendet. Aufgrund dieses Rückmeldesignals wird die reduzierte Gate-Kathodenspannung von der Gateelektrodentreiberstufe in einem zweiten Schritt so weit reduziert, dass der Bipolartransistor mit isoliert angeordneter Gateelektrode abgeschaltet wird.
Durch dieses zweistufige Vorgehen in der Reduzierung der Gate-Kathodenspannung wird eine sehr hohe Störsicherheit erreicht und der Schwellwert der Überwachung der Gate-Kathodenspannung kann sehr nahe an den Betriebswert der Gate-Kathodenspannung gelegt werden, wodurch eine optimale Entlastung des Bipolartransistors mit isoliert angeordneter Gateelektrode bei einem auftretenden Überstrom gewährleistet ist.

Die Vorrichtung zur Durchführung des Verfahrens weist eine erfindungsgemässe Gate-Kathodenspannungsüberwachungeinrichtung auf, die vorteilhafterweise parallel zur Gateelektrodentreiberstufe zwischen der Gateelektrode und der Kathode in Verbindung angeordnet ist. Die Gate-Kathodenspannungsüberwachungseinrichtung umfasst eine Vergleicherschaltung mit einer Hysteresecharakteristik. Die Vergleicherschaltung weist einen Vergleicher auf, der in Verbindung mit einem eingangsseitigen Spannungsteiler und damit verbundener Referenzspannungsquelle und mit einem eingangsseitigen Gate-Kathodenspannungsteiler mit zwischen geschaltetem Eingangswiderstand angeordnet ist. Durch diese Beschaltung des Vergleichers wird vorteilhaft der Schwellwert der Gate-Kathodenspannung festgelegt. Erfindungsgemäss ist der Vergleicher ausgangsseitig in Verbindung mit einem Pull-up-Widerstand und einer damit verbundenen Versorgungsspannungsquelle und mit einem Transistor und damit verbundener Zenerdiode angeordnet. So kann vorteilhaft der einstellbare Wert, auf den die Gate-Kathodenspannung reduziert werden soll, sehr einfach eingestellt werden.

### Kurze Beschreibung der Zeichnungen

Nachfolgend wird die Erfindung anhand von Ausführungsbeispielen im Zusammenhang mit der Zeichnung näher erläutert.

Es zeigen
- **Fig. 1**: eine Ausführungsform einer Vorrichtung zur Durchführung des Verfahrens zur Überstromabschaltung eines Bipolartransistors mit isoliert angeordneter Gateelektrode (IGBT) und
- **Fig.2**: eine Ausführungsform einer Gate-Kathodenspannungsüberwachungseinrichtung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

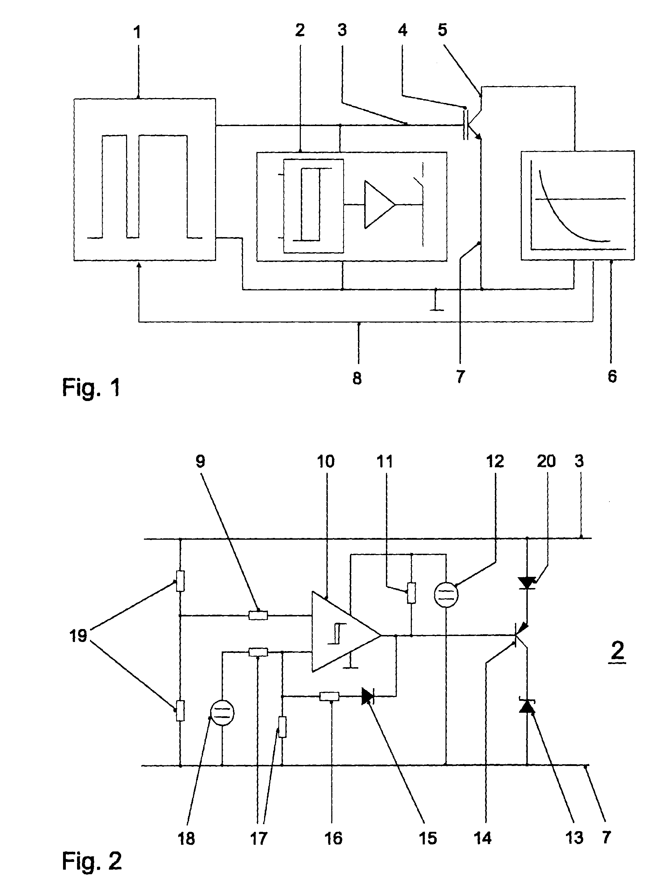

Fig. 1 zeigt eine erfindungsgemässe Ausführungsform der Vorrichtung zur Durchführung des Verfahrens zur Überstromabschaltung eines Bipolartransistors mit isoliert angeordneter Gateelektrode (IGBT). Die Vorrichtung umfasst eine Gateelektrodentreiberstufe 1, die in Verbindung zwischen Gateelektrode 3 und Kathode 7 des Bipolartransistors mit isoliert angeordneter Gateelektrode 4 angeordnet ist und den Bipolartransistor mit isoliert angeordneter Gateelektrode 4 in gängiger Weise über die Gateelektrode 3 durch Anlegen einer Gate-Kathodenspannung ansteuert.
Erfindungsgemäss weist die Vorrichtung gemäss Fig. 1 eine Gate-Kathodenspannungsüberwachungseinrichtung 2 auf, die parallel zur Gateelektrodentreiberstufe 1 zwischen der Gateelektrode 3 und der Kathode 7 in Verbindung angeordnet ist.

Beim erfindungsgemässen Verfahren zur Überstromabschaltung des Bipolartransistors mit isoliert angeordneter Gateelektrode (IGBT) wird die Gate-Kathodenspannung von der Gate-Kathodenspannungsüberwachungseinrichtung auf einen einstellbaren Schwellwert hin überwacht. Fliesst im Bipolartransistor mit isoliert angeordneter Gateelektrode 4 ein Überstrom zwischen der Anode 5 und der Kathode 7, wie er durch einen Kurzschluss in einem Hauptstrompfad eines Stromrichters auftreten kann und der Bipolartransistor mit isoliert angeordneter Gateelektrode 4 in diesem Hauptstrompfad über die Anode 5 und Kathode 7 angeordnet ist, so steigt mit dem Strom zwischen Anode 5 und Kathode 7 die Gate-Kathodenspannung an. Überschreitet die Gate-Kathodenspannung, hervorgerufen durch einen eingangs erwähnten Überstrom, den einstellbaren Schwellwert, so spricht die Überwachung auf Überschreiten des Schwellwertes an und die Gate-Kathodenspannung wird unmittelbar auf einen einstellbaren Wert reduziert. Dadurch kann vorteilhaft erreicht werden, dass der Bipolartransistor mit isoliert angeordneter Gateelektrode 4 in eine niedrigere Entsättigungskennlinie gesteuert wird und somit der auftretende Überstrom zwischen Anode 5 und Katode 7 reduziert wird. Darüberhinaus wird das Gate-Oxid des Bipolartransistors mit isoliert angeordneter Gateelektrode 4 durch die Reduzierung der Gate-Kathodenspannung vor Zerstörung durch Überspannung geschützt. Weiterhin wird durch die sofortige Reduzierung der Gate-Kathodenspannung und die damit einhergehende schnelle Reduzierung der Stromamplitude die momentane Verlustleistung gesenkt.
Vorteilhaft wird der einstellbare Wert der Gate-Kathodenspannung, auf welchen die Gate-Kathodenspannung reduziert werden soll, so eingestellt, dass die reduzierte Gate-Kathodenspannung den Bipolartransistor mit isoliert angeordneter Gateelektrode 4 unmittelbar abschaltet. Durch dieses einstufige Vorgehen wird der zwischen Anode 5 und Kathode 7 auftretende Überstrom schnellstmöglich abgeschaltet.

Eine weitere Möglichkeit des erfindungsgemässen Verfahrens ist die zweistufige Reduzierung der Gate-Kathodenspannung. Das zweistufige Vorgehen besteht darin, dass eine die Anoden-Kathodenspannung des Bipolartransistors mit isoliert angeordneter Gateelektrode 4 auf Entsättigung überwachende Entsättigungsüberwachungseinrichtung 6 bei Entsättigung des Bipolartransistors mit isoliert angeordneter Gateelektrode 4 ein Rückmeldesignal 8 erzeugt, das an die Gateelektrodentreiberstufe 1 gesendet wird. Auf dieses Rückmeldesignal 8 hin wird dann die bereits reduzierte Gate-Kathodenspannung in einem zweiten Schritt so weit reduziert, dass der Bipolartransistor mit isoliert angeordneter Gateelektrode 4 und somit der Überstrom zwischen Anode 5 und Kathode 7 abgeschaltet wird.
Durch dieses zweistufige Vorgehen wird eine extrem hohe Störsicherheit erreicht, wodurch der Schwellwert der Gate-Kathodenspannung zur Überwachung derselben sehr nahe an den normalen Betriebswert der Gate-Kathodenspannung für den Schaltzustand 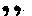 Einschalten" des Bipolartransistors mit isoliert angeordneter Gateelektrode 4 gelegt werden kann. Daraus resultiert eine optimale Entlastung des Bipolartransistors mit isoliert angeordneter Gateelektrode 4 bei einem auftretenden Überstrom zwischen Anode 5 und Kathode 7.

Die erfindungsgemässe Vorrichtung zur Durchführung des Verfahrens umfasst die eingangs erwähnte Entsättigungsüberwachungseinrichtung 6. Diese ist zwischen Anode 5 und Kathode 7 des Bipolartransistors mit isoliert angeordneter Gateelektrode 4 in Verbindung angeordnet und dient der Überwachung auf Entsättigung des Bipolartransistors mit isoliert angeordneter Gateelektrode 4 durch Messung der Anoden-Kathodenspannung. Weiterhin ist die Entsättigungsüberwachungseinrichtung 6 mit der Gateelektrodentreiberstufe 1 verbunden.
Die eingangs erwähnte Gate-Kathodenspannungsüberwachungseinrichtung 2 umfasst gemäss Fig. 2 eine Vergleicherschaltung mit Hysteresecharakteristik. Dabei weist die Vergleicherschaltung einen Vergleicher 10 auf, der in Verbindung mit einem eingangsseitigen Spannungsteiler 17 angeordnet ist. Am Spannungsteiler 17 ist eine Referenzspannungsquelle 18 angeordnet. Zudem ist der Vergleicher 10 eingangsseitig mit einem Gate-Kathodenspannungsteiler 19 und zwischengeschaltetem Eingangswiderstand 9 in Verbindung angeordnet. Durch diese Beschaltung des Vergleichers 10 lässt sich der Schwellwert, auf den die Gate-Kathodenspannung überwacht wird, mit Hilfe der Widerstandsverhältnisse des Spannungsteilers 17 und der Referenzspannungsquelle 18 sowie mit Hilfe der Widerstandsverhältnisse des Gate-Kathodenspannungsteilers 19 mit dem Eingangswiderstand 9 in besonders einfacher Weise auf einen gewünschten Wert einstellen.
Ausgangsseitig ist der Vergleicher 10 gemäss Fig. 2 in Verbindung mit einem Pull-up-Widerstand 11 und einer damit verbundenen Versorgungsspannungsquelle 12 angeordnet. Zusätzlich ist ein Transistor 14 und damit verbundener Zenerdiode 13 in Verbindung mit dem Ausgang des Vergleichers 10 angeordnet. Desweiteren ist der Transistor 14 mit einer Transistordiode 20 verbunden, die in sperrendem Zustand des Transitors 14 die Sperrfähigkeit des Transistors 14 erhöht. Durch diese ausgangsseitige Beschaltung des Vergleichers 10 mittels der erwähnten elektronischen Bauteile 11, 12, 13, 14, 20 und der Wahl der Bauteilgrössen wird der einstellbare Wert der Gate-Kathodenspannung, auf welchen die Gate-Kathodenspannung bei Überschreiten des Schwellwertes reduziert werden soll, eingestellt. Zwischen einem Eingang des Vergleichers 10 und seinem Ausgang ist eine Diode 15 und damit verbundenem Widerstand 16 in Verbindung angeordnet. Diese Beschaltung dient dazu, durch Ändern des Widerstandsverhältnis des Widerstands 16 und des Spannungsteilers 17 über die Diode 15 eine Abschaltschwelle der Gate-Kathodenspannungsüberwachungseinrichtung 2 bei Erreichen des einstellbaren Wertes der Gate-Kathodenspannung zu definieren.

Mittels der beschriebenen eingangsseitigen und der ausgangsseitigen Beschaltung des Vergleichers 10 wird die gewünschte Hysteresecharakteristik der Vergleicherschaltung erreicht. Durch die Hysteresecharkteristik der Vergleicherschaltung ist es sehr einfach möglich, den Bipolartransistor mit isoliert angeordneter Gateelektrode 4 auf den Schwellwert der Gate-Kathodenspannung hin zu überwachen und bei Überschreiten dieses Schwellwertes auf den einstellbaren Wert der Gate-Kathodenspannung zu reduzieren. Dadurch wird eine Reduzierung der Stromamplitude des auftretenden Überstromes zwischen Anode 5 und Kathode 7 des Bipolartransistors mit isoliert angeordneter Gateelektrode 4 und somit die Reduzierung der momentanen Verlustleistung erreicht. Desweiteren ermöglicht die Vergleicherschaltung, den Wert, auf den die Gate-Kathodenspannung reduziert werden soll, so einzustellen, dass der Bipolartransistor mit isoliert angeordneter Gateelektrode 4 unmittelbar abgeschaltet werden kann.
Die Gate-Kathodenspannungsüberwachungseinrichtung 2 und die Entsättigungsüberwachungseinrichtung 6 ermöglichen weiterhin, dass die bereits reduzierte Gate-Kathodenspannung so weit reduziert wird, dass der Bipolartransistor mit isoliert angeordneter Gateelektrode 4 und damit ein auftretender Überstrom abgeschaltet werden kann.

### Bezugszeichenliste

- 1: Gateelektrodentreibersufe
- 2: Gate-Kathodenspannungsüberwachungseinrichtung
- 3: Gateelektrode
- 4: IGBT
- 5: Anode
- 6: Entsättigungsüberwachungseinrichtung
- 7: Kathode
- 8: Rückmeldesignal
- 9: Eingangswiderstand
- 10: Vergleicher
- 11: Pull-up-Widerstand
- 12: Versorgungsspannungsquelle
- 13: Zenerdiode
- 14: Transistor
- 15: Diode
- 16: Widerstand
- 17: Spannungsteiler
- 18: Referenzspannungsquelle
- 19: Gate-Kathodenspannungsteiler
- 20: Transistordiode

## Patentansprüche

1. Verfahren zur Überstromabschaltung eines Bipolartransistors mit isoliert angeordneter Gateelektrode (IGBT) (4), welcher mittels einer die Gate-Kathodenspannung zwischen Gateelektrode (3) und Kathode (7) anlegenden Gateelektrodentreiberstufe (1) angesteuert wird, dadurch gekennzeichnet,
dass die Gate-Kathodenspannung mittels einer Gate-Kachodenspannungsüberwachungseinrichtung (2) auf einen einstellbaren Schwellwert hin überwacht wird und bei Ansprechen der Überwachung auf Überschreiten des Schwellwertes unmittelbar auf einen einstellbaren Wert reduziert wird.

2. Verfahren nach Anspruch 1, dadurch gekennzeichnet, dass der einstellbare Wert der Gate-Kathodenspannung so eingestellt wird, dass die reduzierte Gate-Kathodenspannung den Bipolartransistor mit isoliert angeordneter Gateelektrode (4) unmittelbar abschaltet.

3. Verfahren nach Anspruch 1, dadurch gekennzeichnet, dass eine die Anoden-Kathodenspannung des Bipolartransistor mit isoliert angeordneter Gateelektrode (4) auf Entsättigung überwachende Entsättigungsüberwachungseinrichtung (6) ein Rückmeldesignal (8) erzeugt und das Rückmeldesignal (8) an die Gateelektrodentreiberstufe (1) gesendet wird.

4. Verfahren nach Anspruch 3, dadurch gekennzeichnet, dass durch das Rückmeldesignal (8) die Gateelektrodentreiberstufe (1) die reduzierte Gate-Kathodenspannung in einem zweiten Schritt so weit reduziert, dass der Bipolartransistor mit isoliert angeordneter Gateelektrode (4) abgeschaltet wird.

5. Vorrichtung zur Durchführung des Verfahrens zur Überstromabschaltung eines Bipolartransistors mit isoliert angeordneter Gateelektrode (IGBT) (4), welche eine Gateelektrodentreiberstufe (1) umfasst und in Verbindung zwischen Gateelektrode (3) und Kathode (7) des Bipolartransistors mit isoliert angeordneter Gateelektrode (4) angeordnet ist, dadurch gekennzeichnet,
dass eine Gate-Kathodenspannungsüberwachungseinrichtung (2), die eine Vergleicherschaltung mit einer Hysteresecharakteristik aufweist, parallel zur Gateelektrodentreiberstufe (1) zwischen der Gateelektrode (3) und der Kathode (7) in Verbindung angeordnet ist.

6. Vorrichtung nach Anspruch 5, dadurch gekennzeichnet, dass die Vergleicherschaltung einen Vergleicher (10) aufweist, der in Verbindung mit einem eingangsseitigen Spannungsteiler (17) und damit verbundener Referenzspannungsquelle (18) und mit einem eingangsseitigen Gate-Kathodenspannungsteiler (19) mit zwischengeschaltetem Eingangswiderstand (9) angeordnet ist.

7. Vorrichtung nach Anspruch 6, dadurch gekennzeichnet, dass der Vergleicher (10) ausgangsseitig in Verbindung mit einem Pull-up-Widerstand (11) und einer damit verbundenen Versorgungsspannungsquelle (12) und mit einem Transistor (14) und damit verbundener Zenerdiode (13) angeordnet ist, wobei der Transistor (14) zusätzlich mit einer Transistordiode (20) verbunden ist.

8. Vorrichtung nach Anspruch 6, dadurch gekennzeichnet, dass zwischen einem Eingang des Vergleichers (10) und seinem Ausgang eine Diode (15) mit damit verbundenem Widerstand (16) in Verbindung angeordnet ist.

9. Vorrichtung nach Anspruch 5, dadurch gekennzeichnet, dass eine Entsättigungsüberwachungseinrichtung (6) zwischen Anode (5) und Kathode (7) des Bipolartransistors mit isoliert angeordneter Gateelektrode (4) in Verbindung angeordnet und mit der Gateelektrodentreiberstufe (1) verbunden ist.
